# EUROPEAN PATENT SPECIFICATION

(11) **EP 4 471 848 B1**
(45) Date of publication and mention of the grant of the patent: **10.09.2025**
(21) Application number: 24178045.1
(22) Date of filing: 24.05.2024
(51) Int. Cl.: H01L 23/467, H01L 23/473, H05K 7/20

(54) **COOLING STRUCTURE, ELECTRIC POWER CONVERTER COMPRISING SUCH COOLING STRUCTURE AND VEHICLE**
KÜHLSTRUKTUR, STROMWANDLER MIT SOLCH EINER KÜHLSTRUKTUR UND FAHRZEUG
STRUCTURE DE REFROIDISSEMENT, CONVERTISSEUR DE PUISSANCE ÉLECTRIQUE COMPRENANT UNE TELLE STRUCTURE DE REFROIDISSEMENT ET VÉHICULE

(30) Priority: 01.06.2023 FR 2305474
(43) Date of publication of application: 04.12.2024
(73) Proprietor: Valeo eAutomotive Germany GmbH, 91056 Erlangen (DE)
(72) Inventor: FAKES, Michel, 94046 Creteil Cedex (FR); SMIT, Arnoud, 91056 Erlangen (DE); HECHT, Michael, 91056 Erlangen (DE); KHOT, Shaunak, 94046 Creteil Cedex (FR); ANBAZHAGAN, Arunprasad, 600130 Tamil Nadu (IN); KUNTZE, Friedhelm, 91056 Erlangen (DE)
(74) Representative: Valeo Powertrain Systems

(56) References cited:
- WO-A1-2022/248427
- WO-A2-2012/028144

## Description

The invention relates to a cooling structure and an electric power converter, in particular inverter, comprising such a cooling structure. The invention also relates to a vehicle with such an electric power converter.

Electric power converters like inverters are used to generate an alternating voltage, in particular a multiphase alternating voltage, for operating an electric machine from a direct voltage supplied by a battery. The electric machine can be used as an electric motor to drive a wheel or an axle of an electrically driven vehicle.

The electric power converter comprises controllable switches, for instance controllable semiconductor switches such as IGBTs. During operation of the electric power converter a substantial amount of heat is generated, which must be dissipated, in order to keep the operating temperature of the semiconductors below a predetermined limit.

EP 2416483 A2 describes a doubled sided single phase power module, which is directly cooled. In particular, the power module comprises a plate from which pins project. The pins are intended to be inserted into an opening of a flow path so that a coolant flowing through the flow path comes into contact with the pins.

WO 2022/248427 A1 discloses a cooling structure comprising several layers and a network of local chambers distributed between the several layers stacked one on another according to a stacking direction, wherein each local chamber comprises at least two apertures, of which at least one is in communication with a local chamber of another of the layers, and wherein each local chamber comprises one or several meander-like structures blocking any direct path in the local chamber between the two apertures. In each local chamber, the coolant flowing between the two apertures is forced to get in contact with at least one meander-like structure, so that heat may be relatively easily transferred from a wall of the meander-like structure to the coolant. Each layer comprises one or more of the meander-like structures. between the inlet of the cooling structure and the outlet the temperature of the coolant increases, whereby heat is dissipated from the power module comprising the cooling structure.

The object of the invention is to provide a cooling structure with a more homogeneous temperature distribution.

This object is achieved by a cooling structure with the features of claim 1.

The inventive cooling structure comprises: a fluid distribution layer with a first opening and a second opening for a cooling fluid, which are arranged at opposite sides of the fluid distribution layer, an elongated inner area, in which the first opening is positioned, an elongated outer area, in which the second opening is positioned, with two side arms, which partly surround the inner area, a barrier separating the inner area and the outer area, wherein the width of the inner area decreases along a direction from the first opening to the second opening.

The inventive cooling structure is particularly well-suited for an electric power converter comprising several semiconductor switches, as the cooling structure ensures that the semiconductor switches are cooled homogeneously. Another advantage of the invention is that the pressure loss of the cooling fluid is lower compared to the structure of WO 2022/248427 A1, so that less energy is required for conveying the cooling fluid in a closed circuit.

The first opening in the fluid distribution layer can be an inlet for cooling fluid and the second opening can be an outlet. However, an alternative embodiment is also possible, in which inlet and outlet are reversed, which leads to a reversed flow of the cooling fluid.

As mentioned above, the width of the inner area decreases along a direction from the first opening, preferably the inlet, to the second opening, preferably the outlet. Preferably, the width of the outer area of the fluid distribution layer increases.

It is preferred that the barrier has a U shape or a V shape. With such a shape it can be ensured that the width of the inner area decreases from the inlet to the outlet, in longitudinal direction of the cooling structure, whereas the width of the outer area increases.

"U shape" and "V shape" are to be understood in a broad sense. The legs of a U shape barrier are not necessarily perpendicular. A barrier with a U shape can have legs which are slightly inclined outwards. Such a barrier with a U shape can have a middle part which is comparatively shorter than its legs. On the other hand, a barrier with a V shape does not necessarily have a sharp edge. The connection of the legs of a V shape barrier can also be rounded.

According to a preferred embodiment it can be envisaged that the width of the inner area decreases stepwise. This structure enables to adapt the flow sensitively to the position of several semiconductor switches, which are positioned next to each other in longitudinal direction of the cooling structure.

It is also possible that outer edges of the inner area are inclined to an axis from the inlet to the outlet. The outer edge of the inner area may be divided into several parts, wherein each part has a different inclination with regard to the longitudinal axis. An inventive cooling structure with inclined outer edges can as well be adapted very precisely in order to influence the flow of the cooling fluid.

It is particularly preferred that the inner area and the outer area are essentially symmetrical to an axis from the inlet to the outlet. This feature will also contribute to a homogeneous temperature distribution

Preferably, a fluid separation plate is arranged between the fluid distribution layer and stacked layers of the cooling structure, wherein the fluid separation plate comprises through openings, which are either in communication with the inner area or the outer area. Further preferably, the through openings in the fluid separation plate are at the same position as the semiconductor switches of the inverter, so that the cooling fluid is conveyed to the correct position.

In this regard, it can also be envisaged that the through openings are formed as slits which are arranged along a direction from the inlet to the outlet. Such slits do not essentially impair the flow pressure.

The inventive cooling structure may comprise several layers and a network of local chambers distributed between the several layers stacked one on another according to a stacking direction, wherein each local chamber comprises at least two apertures, of which at least one is in communication with a local chamber of another of the layers, wherein each local chamber comprises one or several meander-like structures blocking any direct path in the local chamber between the two apertures. The invention enables to dissipate heat from power electronic components having a high power density.

The invention further relates to an electric power converter, in particular an inverter, comprising a power module with semiconductor power components, arranged on a substrate, a base plate, on which the substrate is arranged, and an inventive cooling structure, arranged below the base plate.

Preferably, the inverter is a multiphase inverter, wherein the through openings in the fluid separation plate, in particular the slits, are arranged in rows, wherein the number of rows corresponds to the number of phases.

Preferably, the cooling structure is received in a housing with an inlet and an outlet for cooling fluid.

The invention further relates to a vehicle, comprising a battery, a multiphase electric motor configured to drive at least one wheel and an inventive electric power converter.

The invention is explained by means of a preferred example with reference to the drawings. The drawings are schematic representations and show:

- Fig. 1: a top view of a fluid distribution layer;
- Fig. 2: a top view of a fluid separation plate;
- Fig. 3: a cross meander layer;
- Fig. 4: several cross meander layers;
- Fig. 5: an upper plate;
- Fig. 6: a sectional side view of the inventive cooling structure;
- Fig. 7: a sectional view of a cooling structure;
- Fig. 8: a second embodiment of a fluid distribution layer; and
- Fig. 9: an inventive vehicle.

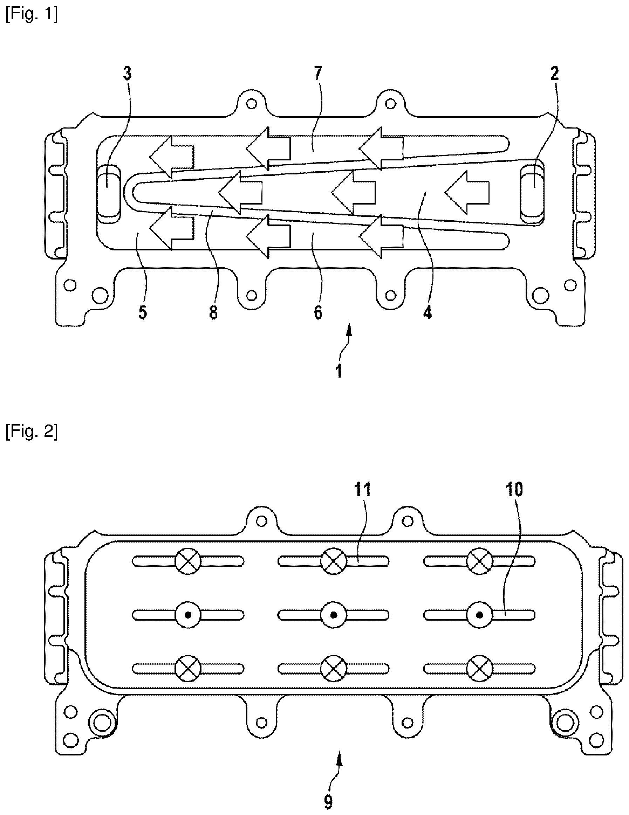

Fig. 1 is a top view of a rectangular fluid distribution layer 1 which has an approximate rectangular shape. The fluid distribution layer 1 is a component of a cooling structure. An inlet 2 for a cooling fluid and an outlet 3 are arranged at opposite sides of the fluid distribution layer 1. The inlet 2 is positioned in an elongated inner area 4. An elongated outer area 5 is provided with two side arms 6, 7, which partly surround the inner area 4. A barrier 8 separates the inner area 4 from the outer area 5. In the embodiment of Fig. 1 the barrier 8 has a V shape. Along the longitudinal direction, which extends between the inlet and the outlet, the width of the inner area 4 decreases, whereas the width of the outer area 5 increases. The inner area 4 and the outer area 5 are essentially symmetrical to a longitudinal axis, which extends between the inlet 2 and the outlet 3.

Fig. 2 shows a fluid separation plate 9, which in the installed state is arranged on top of the fluid distribution layer 1. The fluid separation plate 9 comprises three through openings 10, which are arranged in a row in longitudinal direction. The through openings 10 are placed along the centre of the fluid separation plate 9, so that they are in communication with the inner area 4 of the fluid distribution layer 1. In addition, further through openings 11 are arranged on both sides of the through openings 10. The through openings 10 and the further through openings 11 are arranged in parallel with each other. All through openings 10, 11 are formed as slits. The through openings 10 in the middle are marked with a dot, the outer through openings 11 are marked with a cross. These signs symbolize the flow direction. A dot stands for cooling fluid flowing downward, out of the plane, whereas a cross stands for cooling fluid flowing downward, into the plane. The function of the fluid separation plate 9 is to distribute the cooling fluid between several power modules. In the illustrated example three power modules are present, which are arranged on top of the cooling structure.

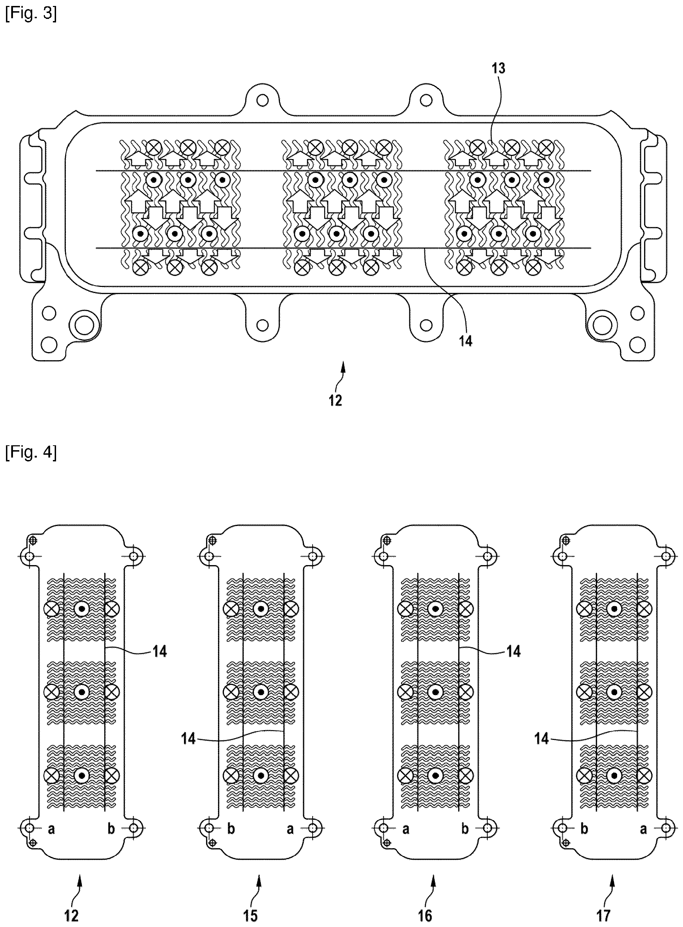

Fig. 3 shows a cross meander layer 12, which is positioned on top of the fluid separation plate 9. In this embodiment the cross meander plate 12 comprises three distinct and identical meander areas 13, each having an approximate square shape. Each meander area 13 comprises meander structures, which are oriented in transverse direction. The meander areas 13 are separated from each other by transverse separators. Cold cooling fluid from the fluid separation plate 9 goes upward and enters the middle of the cross meander layer 12, which is indicated by the dots. The middle part of the cross meander layer 12 is restricted by two parallel barriers 14, which are represented by lines. Due to the meander structure the cold cooling fluid absorbs heat from the cross meander layer 12, which is made from metal, and is warmed up. The separators between the meander areas 13 and the barriers 14 cause that cooling fluid which is between the parallel barriers 14 can only flow further upward. As indicated by the crosses, hot cooling fluid in both outer parts of the cross meander layer 12 flows downward to the fluid separation plate 9. It is noted that the width of both outer parts of the cross meander layer 12 is different, which means that the barriers 14 are not arranged symmetrical to the centre line (longitudinal axis).

Fig. 4 shows in total four cross meander layers, which are stacked one on another. The first cross meander layer 12 has been described before. The second cross meander layer 15 has a similar structure as the first cross meander layer 12, except for the position of the barriers 14. The parallel barriers 14 of the first cross meander layer 12 are shifted a certain amount from the centre line to the right side, whereas the barriers 14 of the second cross meander layer 15 are shifted a certain amount from the centre line to the left side. A third cross meander layer 16 is identical to the first cross meander layer 12 and a fourth cross meander layer 17 is identical to the second cross meander layer 15. As the position of the barriers 14 is not symmetrical to the centre line and alternates from one layer to the following cooling fluid is forced to mix and to go upwards and downwards. The stacked layers 12, 15, 16, 17 create a 3D structure circuit.

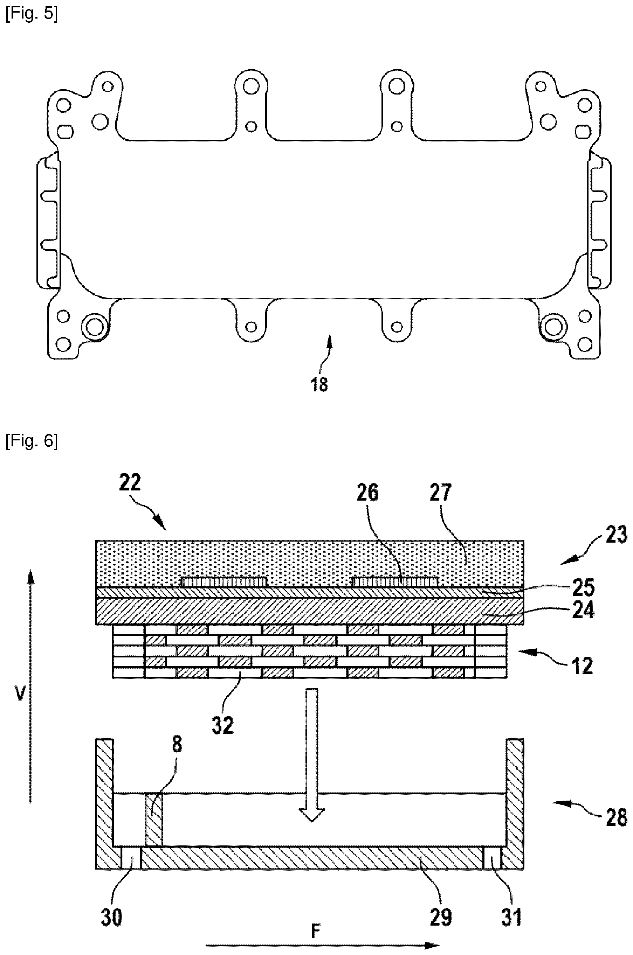

Fig. 5 shows an upper plate 18, which is placed on top of the fourth cross meander layer 17, which seals the cooling structure and which ensures a good thermal connection with the power modules.

Fig. 6 is a sectional view along the flow direction of an inverter 22 which is configured to convert a DC voltage into an AC voltage. The arrow "V" denotes the vertical direction. The arrow "F" denotes the flow direction. The inverter 22 comprises a DC link capacitor (not shown) configured to smooth the DC voltage. Conversion of the DC voltage into the AC voltage is performed by a power module 23 comprising a base plate 24 and a substrate 25 fixed on a top face of the base plate 24. The power module 23 further comprises controllable switches, which are semiconductor power components 26 supported by the substrate 25. The power module 23 comprises an electrically insulating housing 27 surrounding the substrate 25 and the semiconductor power components 26, while a downward face of the base plate 24 is uncovered. The power module 23 further comprises a cooling structure 28 which is fixed at the bottom face of the base plate 24.

A sectional view of a fluid distribution layer 29, which is configured to guide the cooling fluid, is depicted below the power module 23. The fluid distribution layer 29 comprises an inlet 30 and an outlet 31. In the sectional view the barrier 8 between the inner area and the outer area is visible as well. The cooling structure 28 has elongated side walls and is configured to be fixed to the power module 23, so that stacked cross meander layers 12 are received in a cavity of the cooling structure. The cooling structure 28 and the inverter 22 comprising the power module 23 are fixed to each other and sealed.

The coolant is intended to cross chambers 32 in the meander areas of the cross meander layers 12 along the direction of flow F perpendicular to the vertical direction V for flowing from the inlet 30 to the outlet 31. The chambers 32 are formed by holes and are distributed between several cross meander layers 12 stacked on one another along the vertical direction. Each layer comprises meander like structures, as shown in Fig. 3. The chambers are stacked in an offset manner, so that for flowing between two consecutive chambers 32 the cooling fluid has to pass through one chamber of another cross meander layer 12. In order to allow the flow of coolant between chambers of different layers, each chamber 32 overlaps with chambers of an adjacent layer. The overlap between two chambers 32 of adjacent layers forms a cooling fluid aperture allowing coolant communication between these two chambers 32. When the cooling fluid flows through the cross meander layers 12, heat which is generated by the semiconductor power components 26 is dissipated from the base plate 24.

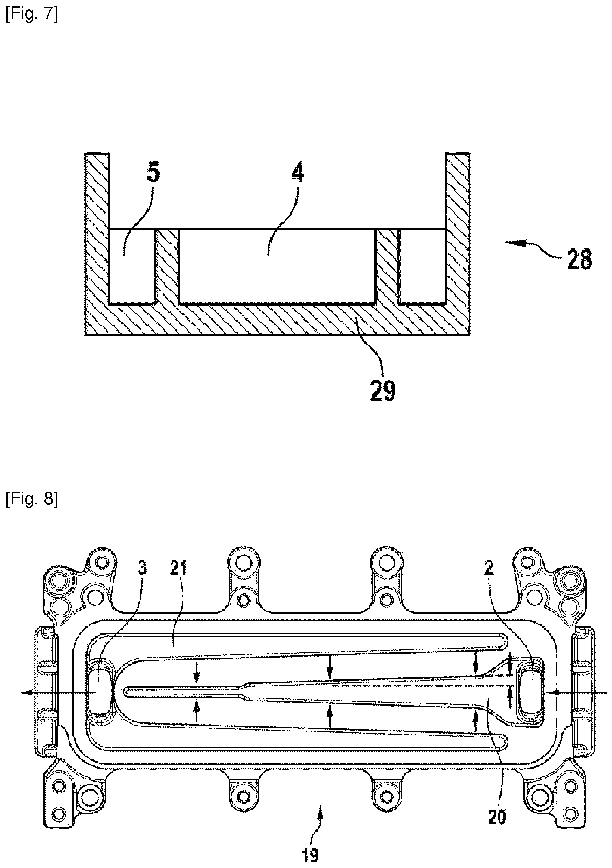

Fig. 7 is a sectional view of the cooling structure 28 shown in Fig. 6 perpendicular to the flow direction. The barrier 8 separates the inner area 4 from two outer areas 5.

Fig. 8 shows a second embodiment of a fluid distribution layer 19, which is similar to the fluid distribution layer 1. The fluid distribution layer 19 has an inlet 2, an outlet 3, an elongated inner area 20, which is surrounded by an outer area 21. In contrast with the first embodiment the widths of the inner area 20 decrease stepwise from the inlet to the outlet. The inner area 20 comprises three regions, which are symmetrical with regard to the centre line. The widths of these regions decrease from the inlet 2 to the outlet 3.

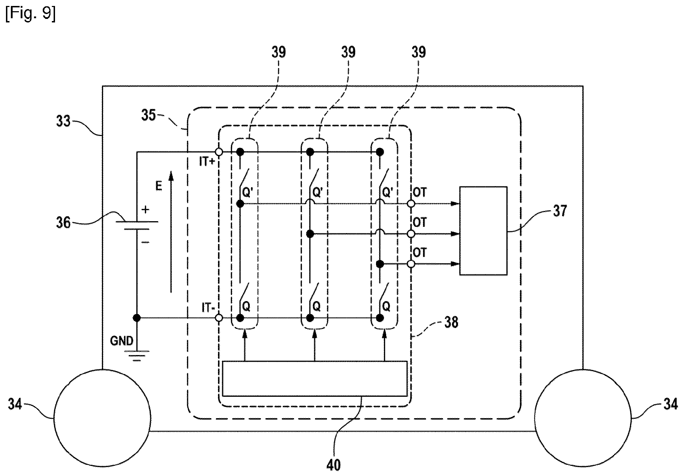

Fig. 9 shows an automotive vehicle 33, comprising wheels 34 and an electric drive 35 configured to drive one or more wheels directly or indirectly. The vehicle 33 comprises a DC voltage source 36, such as a battery, for electrically powering the electric drive 35. The DC voltage source 36 is configured to provide a DC voltage E.

The electric drive 35 comprises an electric motor 37 and an inverter 38 configured to drive the electric motor 37 by supplying electric power. In this embodiment, the electric motor 37 is a rotary electric motor comprising stator phases. In the described example, the electric motor 37 is a three-phase electric motor comprising three stator phases.

The inverter 38 comprises input terminals IT+, IT- connected to the DC voltage source 36 so that the DC voltage E is present at the input terminals IT+, IT-. More precisely, the input terminals IT+, IT- include a positive input terminal IT+

connected to a positive terminal of the DC voltage source 36 and a negative input terminal IT- connected to a negative terminal of the DC voltage source 106 and to an electrical ground GND.

The inverter 38 further comprises output terminals OT connected to the electric motor 37. An AC voltage is intended to be present at the output terminals OT for powering the electric motor 37. The AC voltage may be a single or a multiphase AC voltage. In the described example where the electric motor 37 is a three-phase electric motor, the AC voltage is a three-phase AC voltage.

The inverter 38 further comprises controllable switches Q, Q', called main switches, connected to the input terminals IT+, IT- and to the output terminals OT. The main switches Q, Q' are semiconductor switches comprising for example transistors. Each main switch Q, Q' comprises for example one amongst: a Metal Oxide Semiconductor Field Effect Transistor (MOSFET), an Insulated Gate Bipolar Transistor (IGBT) and a Silicon Carbide MOSFET (SiC MOSFET). These switches Q, Q' correspond to the semiconductor power components 26 of Fig. 6. In the described embodiment, the inverter 38 comprises switch elements 39 respectively associated to the stator phases of the electric motor 37. Each switch element 39 comprises a high side (HS) main switch Q' connected to the positive input terminal IT+ and a low side (LS) main switch Q connected to the negative input terminal IT. The HS main switch Q' and the LS main switch Q are connected to each other at a middle point connected to the output terminal OT connected to the associated stator phase of the electric motor 37.

Each switch element 39 is intended to be controlled to commute between two configurations. In the first one, called high side (HS) configuration, the HS main switch Q' is closed (on) and the LS main switch Q is open (off) so that the DC voltage E is essentially applied to the associated stator phase. In the second one, called low side (LS) configuration, the HS main switch Q' is open (off) and the LS main switch Q is closed (on) so that a zero voltage is essentially applied to the associated stator phase.

The inverter 38 further comprises a control device 40 configured to control the main switches Q, Q' such that the main switches Q, Q' convert the DC voltage E into the AC voltage. In the described example, the control device 40 is configured to commute each switch element 39 between the two configurations mentioned above. The power module 23 could implement, for example, one of the switch elements 39 or all the switch elements 39.

## Claims

1. Cooling structure (28), comprising:
- a fluid distribution layer (1, 19, 29) with
- a first opening and a second opening for a cooling fluid, which are arranged at opposite sides of the fluid distribution layer (1, 19, 29),
- an elongated inner area (4, 20), in which the first opening is positioned,
- an elongated outer area (5, 21), in which the second opening is positioned, with two side arms (6, 7), which partly surround the inner area (4, 20),
- a barrier (8) separating the inner area (4, 20) and the outer area (5, 21), wherein the width of the inner area (4, 20) decreases along a direction from the first opening to the second opening.

2. Cooling structure according to claim 1, wherein the first opening is an inlet (2) for the cooling fluid and the second opening is an outlet (3) or vice versa.

3. Cooling structure according to claim 1 or 2, wherein the width of the outer area (5, 21) increases along a direction from the first opening to the second opening.

4. Cooling structure according to any of the preceding claims, wherein the barrier (8) has a U shape or a V shape.

5. Cooling structure according to any of the preceding claims, wherein the width of the inner area (4, 20) decreases stepwise.

6. Cooling structure according to any of the preceding claims, wherein outer edges of the inner area (4, 20) are inclined to an axis from the first opening, in particular the inlet (2), to the second opening, in particular the outlet (3).

7. Cooling structure according to any of the preceding claims, wherein the inner area (4, 20) and the outer area (5, 21) are essentially symmetrical to an axis from the first opening, in particular the inlet (2), to the second opening, in particular the outlet (3).

8. Cooling structure according any of the preceding claims, wherein a fluid separation plate (9) is arranged between the fluid distribution layer (1, 19, 29) and stacked layers (12, 15, 16, 17) of the cooling structure (28), wherein the fluid separation plate (9) comprises through openings (10, 11), which are either in communication with the inner area (4, 20) or the outer area (5, 21).

9. Cooling structure according to claim 8, wherein the through openings (10, 11) are formed as slits arranged along a direction from the inlet (2) to the outlet (3).

10. Cooling structure according any of the preceding claims, comprising several layers (12, 15, 16, 17) and a network of local chambers (32) distributed between the several layers (12, 15, 16, 17) stacked one on another according to a stacking direction, wherein each local chamber (32) comprises at least two apertures, of which at least one is in communication with a local chamber (32) of another of the layers (12, 15, 16, 17), wherein each local chamber (32) comprises one or several meander-like structures blocking any direct path in the local chamber (32) between the two apertures.

11. Electric power converter, in particular inverter (38), comprising:
- a power module (23) with semiconductor power components (26), arranged on a substrate (25),
- a base plate (24), on which the substrate (25) is arranged, and
- a cooling structure (28) according to any of claims 1 to 10, arranged below the base plate (24).

12. Electric power converter according to claim 11, wherein the inverter (38) is a multiphase inverter, wherein the through openings (10, 11) in the fluid separation plate (9), in particular the slits, are arranged in rows, wherein the number of rows corresponds to the number of phases.

13. Electric power converter according to claim 11 or 12, wherein the cooling structure (28) is received in a housing (27) with an inlet (30) and an outlet (31) for cooling fluid.

14. Vehicle (33), comprising a battery, a multiphase electric motor (37) configured to drive at least one wheel and an electric power converter according to any of claims 11 to 13.

## Patentansprüche

1. Kühlstruktur (28), umfassend:
- einer Fluidverteilungsschicht (1, 19, 29) mit
- einer ersten Öffnung und einer zweiten Öffnung für ein Kühlfluid, die an gegenüberliegenden Seiten der Fluidverteilungsschicht (1, 19, 29) angeordnet sind,
- einen länglichen Innenbereich (4, 20), in dem die erste Öffnung angeordnet ist,
- einem länglichen Außenbereich (5, 21), in dem die zweite Öffnung positioniert ist, mit zwei Seitenarmen (6, 7), die den Innenbereich (4, 20) teilweise umgeben,
- eine den Innenbereich (4, 20) und den Außenbereich (5, 21) trennende Barriere (8), wobei die Breite des Innenbereichs (4, 20) in Richtung von der ersten Öffnung zur zweiten Öffnung abnimmt.

2. Kühlstruktur nach Anspruch 1, wobei die erste Öffnung eine Einlassöffnung (2) für das Kühlfluid und die zweite Öffnung eine Auslassöffnung (3) ist oder umgekehrt.

3. Kühlstruktur nach Anspruch 1 oder 2, wobei die Breite des Außenbereichs (5, 21) in Richtung von der ersten Öffnung zur zweiten Öffnung zunimmt.

4. Kühlstruktur nach einem der vorstehenden Ansprüche, wobei die Barriere (8) eine U-Form oder eine V-Form aufweist.

5. Kühlstruktur nach einem der vorstehenden Ansprüche, wobei die Breite des Innenbereichs (4, 20) stufenweise abnimmt.

6. Kühlstruktur nach einem der vorstehenden Ansprüche, wobei die Außenkanten des Innenbereichs (4, 20) zu einer Achse von der ersten Öffnung, insbesondere dem Einlass (2), zur zweiten Öffnung, insbesondere dem Auslass (3), geneigt sind.

7. Kühlstruktur nach einem der vorstehenden Ansprüche, wobei der Innenbereich (4, 20) und der Außenbereich (5, 21) im Wesentlichen symmetrisch zu einer Achse von der ersten Öffnung, insbesondere dem Einlass (2), zur zweiten Öffnung, insbesondere dem Auslass (3), sind.

8. Kühlstruktur nach einem der vorstehenden Ansprüche, wobei zwischen der Fluidverteilungsschicht (1, 19, 29) und den gestapelten Schichten (12, 15, 16, 17) der Kühlstruktur (28) angeordnet ist, wobei die fluid e Trennplatte (9) Durchgangsöffnungen (10, 11) aufweist, die entweder mit dem Innenbereich (4, 20) oder dem Außenbereich (5, 21) in Verbindung stehen.

9. Kühlstruktur nach Anspruch 8, wobei die Durchgangsöffnungen (10, 11) als Schlitze ausgebildet sind, die entlang einer Richtung vom Einlass (2) zum Auslass (3) angeordnet sind.

10. Kühlstruktur nach einem der vorstehenden Ansprüche, mit mehreren Schichten (12, 15, 16, 17) und ein Netzwerk aus lokalen Kammern (32) umfasst, die zwischen den mehreren Schichten (12, 15, 16, 17) verteilt sind, die gemäß einer Stapelrichtung übereinander gestapelt sind, wobei jede lokale Kammer (32) mindestens zwei Öffnungen umfasst, von denen mindestens eine mit einer lokalen Kammer (32) einer anderen der Schichten (12, 15, 16, 17) in Verbindung steht, wobei jede lokale Kammer (32) eine oder mehrere mäanderartige Strukturen aufweist, die jeden direkten Weg in der lokalen Kammer (32) zwischen den beiden Öffnungen blockieren.

11. Elektrischer Leistungswandler, insbesondere Wechselrichter (38), mit:
- ein Leistungsmodul (23) mit Halbleiter-Leistungskomponenten (26), die auf einem Substrat (25) angeordnet sind,
- eine Grundplatte (24), auf der das Substrat (25) angeordnet ist, und
- eine Kühlstruktur (28) gemäß einem der Ansprüche 1 bis 10, die unterhalb der Grundplatte (24) angeordnet ist.

12. Elektrischer Leistungswandler nach Anspruch 11, wobei der Wechselrichter (38) ein Mehrphasen-Wechselrichter ist, wobei die Durchgangsöffnungen (10, 11) in der Fluidtrennplatte (9), insbesondere die Schlitze, in Reihen angeordnet sind, wobei die Anzahl der Reihen der Anzahl der Phasen entspricht.

13. Elektrischer Leistungswandler nach A ngen zu Anspruch 11 oder 12, wobei die Kühlstruktur (28) in einem Gehäuse (27) mit einem Einlass (30) und einem Auslass (31) für Kühlfluid aufgenommen ist.

14. Fahrzeug (33), umfassend eine Batterie, einen Mehrphasen-Elektromotor (37), der zum Antreiben mindestens eines Rades konfiguriert ist, und einen elektrischen Leistungswandler gemäß einem der Ansprüche 11 bis 13.

## Revendications

1. Structure de refroidissement (28), comprenant :
- une couche de distribution de fluide (1, 19, 29) avec
- une première ouverture et une deuxième ouverture pour un fluide de refroidissement, qui sont disposées sur des côtés opposés de la couche de distribution de fluide (1, 19, 29),
- une zone intérieure allongée (4, 20) dans laquelle est positionnée la première ouverture,
- une zone extérieure allongée (5, 21), dans laquelle est positionnée la deuxième ouverture, avec deux bras latéraux (6, 7) qui entourent partiellement la zone intérieure (4, 20),
- une barrière (8) séparant la zone intérieure (4, 20) et la zone extérieure (5, 21), la largeur de la zone intérieure (4, 20) diminuant dans une direction allant de la première ouverture vers la deuxième ouverture.

2. Structure de refroidissement selon la revendication 1, dans laquelle la première ouverture est une entrée (2) pour le fluide de refroidissement et la deuxième ouverture est une sortie (3) ou vice versa.

3. Structure de refroidissement selon la revendication 1 ou 2, dans laquelle la largeur de la zone extérieure (5, 21) augmente dans une direction allant de la première ouverture vers la deuxième ouverture.

4. Structure de refroidissement selon l'une quelconque des revendications précédentes, dans laquelle la barrière (8) a une forme en U ou en V.

5. Structure de refroidissement selon l'une quelconque des revendications précédentes, dans laquelle la largeur de la zone intérieure (4, 20) diminue par paliers.

6. Structure de refroidissement selon l'une quelconque des revendications précédentes, dans laquelle les bords extérieurs de la zone intérieure (4, 20) sont inclinés par rapport à un axe allant de la première ouverture, en particulier l'entrée (2), à la deuxième ouverture, en particulier la sortie (3).

7. Structure de refroidissement selon l'une quelconque des revendications précédentes, dans laquelle la zone intérieure (4, 20) et la zone extérieure (5, 21) sont essentiellement symétriques par rapport à un axe allant de la première ouverture, en particulier l'entrée (2), à la deuxième ouverture, en particulier la sortie (3).

8. Structure de refroidissement selon l'une quelconque des revendications précédentes, dans laquelle une plaque de séparation de fluide (9) est disposée entre la couche de distribution de fluide (1, 19, 29) et les couches empilées (12, 15, 16, 17) de la structure de refroidissement (28), dans laquelle la plaque de séparation de fluide (9) comprend des ouvertures traversantes (10, 11) qui sont en communication soit avec la zone intérieure (4, 20), soit avec la zone extérieure (5, 21).

9. Structure de refroidissement selon la revendication 8, dans laquelle les ouvertures traversantes (10, 11) sont formées comme des fentes disposées le long d'une direction allant de l'entrée (2) à la sortie (3).

10. Structure de refroidissement selon l'une quelconque des revendications précédentes, comprenant plusieurs couches (12, 15, 16, 17) et un réseau de chambres locales (32) réparties entre les différentes couches (12, 15, 16, 17) empilées les unes sur les autres selon une direction d'empilement, dans laquelle chaque chambre locale (32) comprend au moins deux ouvertures, dont au moins une est en communication avec une chambre locale (32) d'une autre des couches (12, 15, 16, 17), dans lequel chaque chambre locale (32) comprend une ou plusieurs structures en forme de méandres bloquant tout chemin direct dans la chambre locale (32) entre les deux ouvertures.

11. Convertisseur de puissance électrique, en particulier onduleur (38), comprenant :
- un module de puissance (23) avec des composants de puissance à semiconducteurs (26), disposés sur un substrat (25),
- une plaque de base (24) sur laquelle est disposé le substrat (25), et
- une structure de refroidissement (28) selon l'une quelconque des revendications 1 à 10, disposée sous la plaque de base (24).

12. Convertisseur de puissance électrique selon la revendication 11, dans lequel l'onduleur (38) est un onduleur polyphasé, dans lequel les ouvertures traversantes (10, 11) dans la plaque de séparation de fluide (9), en particulier les fentes, sont disposées en rangées, le nombre de rangées correspondant au nombre de phases.

13. Convertisseur de puissance électrique selon l' r à la revendication 11 ou 12, dans lequel la structure de refroidissement (28) est logée dans un boîtier (27) avec une entrée (30) et une sortie (31) pour le fluide de refroidissement.

14. Véhicule (33) comprenant une batterie, un moteur électrique multiphase (37) configuré pour entraîner au moins une roue et un convertisseur de puissance électrique selon l'une quelconque des revendications 11 à 13.
